# EUROPEAN PATENT APPLICATION

(11) **EP 4 583 658 A1**
(43) Date of publication of application: **09.07.2025**
(21) Application number: 25150073.2
(22) Date of filing: 02.01.2025
(51) Int. Cl.: H10B 12/00, H10D 30/67

(54) **VERTICALLY STACKED MEMORY DEVICE AND ELECTRONIC APPARATUS INCLUDING THE SAME**

(30) Priority: 03.01.2024 KR 20240000901
(71) Applicant: Samsung Electronics Co., Ltd., Suwon-si, Gyeonggi-do 16677 (KR)
(72) Inventor: KIM, Sangwook, 16678 Suwon-si (KR); LEE, Kwanghee, 16678 Suwon-si (KR); CHA, Youngkwan, 16678 Suwon-si (KR); JUNG, Kyooho, 16678 Suwon-si (KR)
(74) Representative: Elkington and Fife LLP

(57) **Abstract**

A vertically stacked memory device includes a plurality of bit lines extending in a first direction, a plurality of oxide semiconductor layers including a plurality of oxide semiconductor layer sets each including one or more oxide semiconductor layers connected to a separate, respective bit line of the plurality of bit lines and extending in a second direction, the second direction intersecting with the first direction, a plurality of capacitors electrically connected to separate, respective oxide semiconductor layers of the plurality of oxide semiconductor layers, and a plurality of word lines extending to intersect with the plurality of oxide semiconductor layers in a third direction intersecting with both the first direction and the second direction, wherein each oxide semiconductor layer includes an oxide semiconductor material in which a proportion of tin (Sn) among all metals therein is about 50 at% or more to about 100 at% or less.

## Description

### FIELD OF THE INVENTION

The inventive concepts relate to vertically stacked memory devices and electronic apparatuses including the same, and more particularly, to vertically stacked memory devices having an oxide semiconductor channel and electronic apparatus including one or a plurality of the vertically stacked memory devices.

### BACKGROUND OF THE INVENTION

A unit memory cell of a typical dynamic random-access memory (DRAM) device includes one transistor and one capacitor and may store information by charging or discharging electric charges in or from the capacitor. As electronic products become compact and deliver higher performance, various structures that may increase the integration of memory devices such as DRAM used in electronic products are being proposed to further increase the capacity of memory devices. For example, due to a limit to reducing the area of a unit memory cell, a memory device with a three-dimensional structure in which a plurality of memory cells are stacked vertically on a substrate has been proposed. However, single crystal silicon, which is mainly used as a channel material in typical unit memory cells, requires a high temperature deposition process, making it difficult to stack a plurality of memory cells.

### SUMMARY OF THE INVENTION

Some example embodiments of the inventive concepts provide a vertically stacked memory device and an electronic apparatus including the same.

Some example embodiments of the inventive concepts provide a vertically stacked memory device having an oxide semiconductor channel and an electronic apparatus including the vertically stacked memory device.

Some example embodiments of the inventive concepts provide a vertically stacked memory device having an oxide semiconductor channel which may have a high etch selectivity with respect to a surrounding insulating layer material and an electronic apparatus including the vertically stacked memory device.

Additional aspects will be set forth in part in the description which follows and, in part, will be apparent from the description, or may be learned by practice of the presented example embodiments of the inventive concepts.

According to some example embodiments of the inventive concepts, a memory device may include a plurality of bit lines extending in a first direction, a plurality of oxide semiconductor layers including a plurality of oxide semiconductor layer sets, each oxide semiconductor layer set including one or more oxide semiconductor layers of the plurality of oxide semiconductor layers connected to a separate, respective bit line of the plurality of bit lines and extending in a second direction, the second direction intersecting with the first direction, a plurality of capacitors electrically connected to separate, respective oxide semiconductor layers of the plurality of oxide semiconductor layers, and a plurality of word lines extending to intersect with the plurality of oxide semiconductor layers in a third direction intersecting with both the first direction and the second direction, wherein at least one oxide semiconductor layer of the plurality of oxide semiconductor layers includes an oxide semiconductor material in which a proportion of tin (Sn) among all metals in the oxide semiconductor material is about 50 at% or more to about 100 at% or less.

An oxide semiconductor material of the at least one oxide semiconductor layer of the plurality of oxide semiconductor layers may have a same composition in an entirety of a cross-sectional area of the at least one oxide semiconductor layer, the cross-sectional area extending in the first and third directions.

The proportion of tin (Sn) among all metals in the oxide semiconductor material may be about 50 at% or more to about 75 at% or less.

The proportion of zinc (Zn) among all metals in the oxide semiconductor material may be 20 at% or less.

The proportion of zinc (Zn) among all metals in the oxide semiconductor material may be 0 at%.

The at least one oxide semiconductor layer of the plurality of oxide semiconductor layers may include a first oxide semiconductor and a second oxide semiconductor, the second oxide semiconductor surrounding an outer surface of the first oxide semiconductor, and a content of tin (Sn) in the second oxide semiconductor may be higher than a content of tin (Sn) in the first oxide semiconductor.

The proportion of tin (Sn) among all metals in the second oxide semiconductor may be about 50 at% or more to about 100 at% or less.

The proportion of zinc (Zn) among all metals in the second oxide semiconductor may be 20 at% or less.

The proportion of tin (Sn) among all metals in the first oxide semiconductor may be 50 at% or less.

A content of zinc (Zn) in the first oxide semiconductor may be higher than a content of zinc (Zn) in the second oxide semiconductor.

The proportion of zinc (Zn) among all metals in the first oxide semiconductor may be 10 at% or more.

A total thickness of the second oxide semiconductor in the first direction may be about 20% to about 40% of a total thickness of the at least one oxide semiconductor layer in the first direction.

The at least one oxide semiconductor layer of the plurality of oxide semiconductor layers may have a composition in which a content of tin (Sn) gradually decreases from an outside of the at least one oxide semiconductor layer to an inside of the at least one oxide semiconductor layer.

The oxide semiconductor material may further include at least one metal of indium (In), gallium (Ga), zinc (Zn), aluminum (Al), silicon (Si), or hafnium (Hf).

The at least one oxide semiconductor layer of the plurality of oxide semiconductor layers may include a channel region facing a corresponding word line among the plurality of word lines in the first direction, a source region contacting a corresponding bit line among the plurality of bit lines in the second direction, and a drain region contacting a corresponding capacitor among the plurality of capacitors in a second direction, and an oxygen content in the channel region may be higher than an oxygen content in the source region and the drain region.

Each word line of the plurality of word lines may include a first word line and a second word line spaced apart from each other in the first direction with a corresponding oxide semiconductor layer among the plurality of oxide semiconductor layers therebetween, the first word line and the second word line being arranged in parallel to each other and facing each other.

Each oxide semiconductor layer set may include a separate plurality of oxide semiconductor layers that are that are connected to a corresponding bit line among the plurality of bit lines and are spaced apart at intervals in the first direction, and a width of each word line of the plurality of word lines in the second direction may be less than a separate width of each oxide semiconductor layer in the second direction.

The memory device may further include a first insulator configured to fill spaces on opposite sides of each of the plurality of word lines in the second direction and a second insulator between two adjacent oxide semiconductor layers of the plurality of oxide semiconductor layers in the first direction, wherein the first insulator includes at least one material of silicon nitride, silicon oxynitride, or aluminum oxide, and the second insulator includes silicon oxide.

The second insulator may be further on opposite sides of each oxide semiconductor layer of the plurality of oxide semiconductor layers in the third direction.

According to another aspect of the inventive concepts, an electronic apparatus includes a memory device, and a memory controller configured to control the memory device to read data from the memory device or write data to the memory device, wherein the memory device includes a plurality of bit lines extending in a first direction, a plurality of oxide semiconductor layers including a plurality of sets of one or more oxide semiconductor layers connected to separate, respective bit lines of the plurality of bit lines and extending in a second direction, the second direction intersecting with the first direction, a plurality of capacitors electrically connected to separate, respective oxide semiconductor layers of the plurality of oxide semiconductor layers, and a plurality of word lines extending to intersect with the plurality of oxide semiconductor layers in a third direction, the third direction intersecting with both the first direction and the second direction, wherein at least one oxide semiconductor layer of the plurality of oxide semiconductor layers includes an oxide semiconductor material in which a proportion of tin (Sn) among all metals is about 50 at% or more to about 100 at% or less.

### BRIEF DESCRIPTION OF THE DRAWINGS

The above and other aspects, features, and advantages of certain embodiments of the inventive concepts will be more apparent from the following description taken in conjunction with the accompanying drawings, in which:
FIG. 1 is a perspective view illustrating a schematic structure of a vertically stacked memory device according to some example embodiments;
FIGS. 2A and 2B are cross-sectional views illustrating examples of various structures of an oxide semiconductor layer of a vertically stacked memory device according to some example embodiments;
FIG. 3 is a perspective view illustrating a schematic structure of a vertically stacked memory device according to some example embodiments;
FIGS. 4, 5, 6, 7, 8, 9, 10, 11, 12, 13, 14, 15, 16, 17, 18, 19, 20, 21, 22, 23, 24, 25, 26, 27, and 28 illustrate a process of manufacturing the vertically stacked memory device illustrated in FIG. 3, according to some example embodiments;
FIG. 29 illustrates a vertical cross-section of a plurality of memory cells of a vertically stacked memory device manufactured through the process illustrated in FIGS. 4 to 28, according to some example embodiments;
FIG. 30 illustrates a vertical cross-section of a plurality of memory cells of a vertically stacked memory device manufactured through the process illustrated in FIGS. 4 to 28, according to some example embodiments;
FIG. 31 is a schematic block diagram of an electronic system including a vertically stacked memory device, according to some example embodiments; and
FIG. 32 is a schematic block diagram of another electronic system including a vertically stacked memory device, according to some example embodiments.

### DETAILED DESCRIPTION

Reference will now be made in detail to example embodiments, some of which are illustrated in the accompanying drawings, wherein like reference numerals refer to like elements throughout. In this regard, the some example embodiments may have different forms and should not be construed as being limited to the descriptions set forth herein. Accordingly, some example embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list.

Hereinafter, a vertically stacked memory device and an electronic apparatus including the same will be described in detail with reference to the attached drawings. In the following drawings, the same reference numerals refer to the same components, and the size of each component in the drawings may be exaggerated for clarity and convenience of explanation. Also, embodiments described herein may have different forms and should not be construed as being limited to the descriptions set forth herein.

It will also be understood that when an element is referred to as being "on" or "above" another element, the element may be in direct contact with the other element or other intervening elements may be present. The singular forms include the plural forms unless the context clearly indicates otherwise. It should be understood that, when a part "comprises" or "includes" an element in the specification, unless otherwise defined, other elements are not excluded from the part and the part may further include other elements.

Throughout the specification, when a part is "connected" to another part, it includes not only a case where the part is "directly connected" but also a case where the part is "indirectly connected" with another part in between. In addition, unless explicitly described to the contrary, the word "comprise" and variations such as "comprises" or "comprising" will be understood to imply the inclusion of stated elements but not the exclusion of any other elements.

The use of all illustrations or illustrative terms in some example embodiments is simply to describe the technical ideas in detail, and the scope of the present inventive concepts is not limited by the illustrations or illustrative terms unless they are limited by claims.

It will be understood that elements and/or properties thereof (e.g., structures, surfaces, directions, or the like), which may be referred to as being "perpendicular," "parallel," "coplanar," or the like with regard to other elements and/or properties thereof (e.g., structures, surfaces, directions, or the like) may be "perpendicular," "parallel," "coplanar," or the like or may be "substantially perpendicular," "substantially parallel," "substantially coplanar," respectively, with regard to the other elements and/or properties thereof.

Elements and/or properties thereof (e.g., structures, surfaces, directions, or the like) that are "substantially perpendicular", "substantially parallel", or "substantially coplanar" with regard to other elements and/or properties thereof will be understood to be "perpendicular", "parallel", or "coplanar", respectively, with regard to the other elements and/or properties thereof within manufacturing tolerances and/or material tolerances and/or have a deviation in magnitude and/or angle from "perpendicular", "parallel", or "coplanar", respectively, with regard to the other elements and/or properties thereof that is equal to or less than 10% (e.g., a. tolerance of ±10%).

It will be understood that elements and/or properties thereof may be recited herein as being "the same" or "equal" as other elements, and it will be further understood that elements and/or properties thereof recited herein as being "identical" to, "the same" as, or "equal" to other elements may be "identical" to, "the same" as, or "equal" to or "substantially identical" to, "substantially the same" as or "substantially equal" to the other elements and/or properties thereof. Elements and/or properties thereof that are "substantially identical" to, "substantially the same" as or "substantially equal" to other elements and/or properties thereof will be understood to include elements and/or properties thereof that are identical to, the same as, or equal to the other elements and/or properties thereof within manufacturing tolerances and/or material tolerances. Elements and/or properties thereof that are identical or substantially identical to and/or the same or substantially the same as other elements and/or properties thereof may be structurally the same or substantially the same, functionally the same or substantially the same, and/or compositionally the same or substantially the same. While the term "same," "equal" or "identical" may be used in description of some example embodiments, it should be understood that some imprecisions may exist. Thus, when one element is referred to as being the same as another element, it should be understood that an element or a value is the same as another element within a desired manufacturing or operational tolerance range (e.g., ±10%).

It will be understood that elements and/or properties thereof described herein as being "substantially" the same and/or identical encompasses elements and/or properties thereof that have a relative difference in magnitude that is equal to or less than 10%. Further, regardless of whether elements and/or properties thereof are modified as "substantially," it will be understood that these elements and/or properties thereof should be construed as including a manufacturing or operational tolerance (e.g., ±10%) around the stated elements and/or properties thereof.

When the terms "about" or "substantially" are used in this specification in connection with a numerical value, it is intended that the associated numerical value includes a manufacturing or operational tolerance (e.g., ±10%) around the stated numerical value. Moreover, when the words "about" and "substantially" are used in connection with geometric shapes, it is intended that precision of the geometric shape is not required but that latitude for the shape is within the scope of the disclosure. Further, regardless of whether numerical values or shapes are modified as "about" or "substantially," it will be understood that these values and shapes should be construed as including a manufacturing or operational tolerance (e.g., ±10%) around the stated numerical values or shapes. When ranges are specified, the range includes all values therebetween such as increments of 0.1%.

As described herein, when an operation is described to be performed, or an effect such as a structure is described to be established "by" or "through" performing additional operations, it will be understood that the operation may be performed and/or the effect/structure may be established "based on" the additional operations, which may include performing said additional operations alone or in combination with other further additional operations.

As described herein, an element that is described to be "spaced apart" from another element, in general and/or in a particular direction (e.g., vertically spaced apart, laterally spaced apart, etc.) and/or described to be "separated from" the other element, may be understood to be isolated from direct contact with the other element, in general and/or in the particular direction (e.g., isolated from direct contact with the other element in a vertical direction, isolated from direct contact with the other element in a lateral or horizontal direction, etc.). Similarly, elements that are described to be "spaced apart" from each other, in general and/or in a particular direction (e.g., vertically spaced apart, laterally spaced apart, etc.) and/or are described to be "separated" from each other, may be understood to be isolated from direct contact with each other, in general and/or in the particular direction (e.g., isolated from direct contact with each other in a vertical direction, isolated from direct contact with each other in a lateral or horizontal direction, etc.). Similarly, a structure described herein to be between two other structures to separate the two other structures from each other may be understood to be configured to isolate the two other structures from direct contact with each other.

The use of the terms "a" and "an" and "the" and similar referents are to be construed to cover both the singular and the plural. The steps of all methods described herein may be performed in any suitable order unless otherwise indicated herein or otherwise clearly contradicted by context.

Also, in the specification, the term "... units" or "...modules" denote units or modules that process at least one function or operation, and may be realized by hardware, software, or a combination of hardware and software.

The connecting lines, or connectors illustrated in the various figures presented are intended to represent example functional relationships and/or physical or logical couplings between the various elements. It should be noted that many alternative or additional functional relationships, physical connections or logical connections may be present in a practical device.

The use of any and all examples, or example language (e.g., "such as") provided herein, is intended merely to better illuminate the inventive concepts and does not pose a limitation on the scope of the inventive concepts unless otherwise claimed.

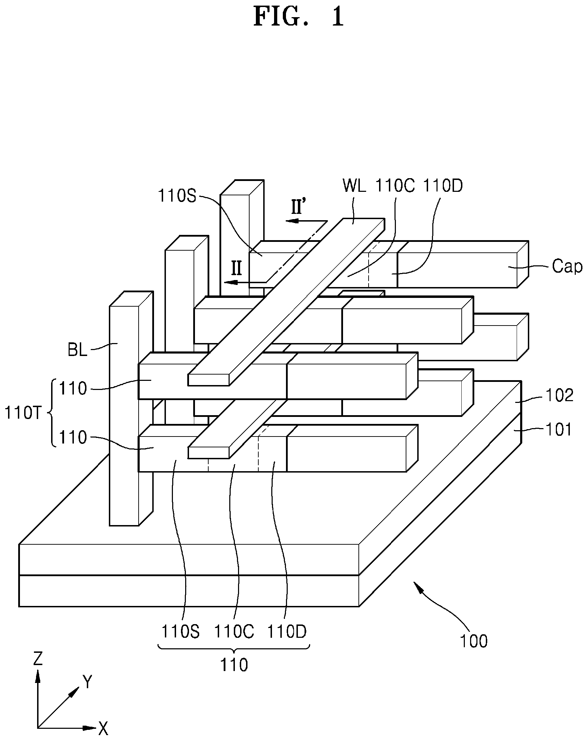

FIG. 1 is a perspective view illustrating a schematic structure of a vertically stacked memory device according to some example embodiments. Referring to FIG. 1, a vertically stacked memory device 100 may include a plurality of bit lines BL extending in a first direction (i.e., Z direction), a plurality of oxide semiconductor layers 110 respectively connected to the plurality of bit lines BL and extending in a second direction vertically intersecting with the first direction (i.e., X direction), a plurality of capacitors Cap electrically connected to separate, respective oxide semiconductor layers 110 of the plurality of oxide semiconductor layers 110, and a plurality of word lines WL extending to intersect with the plurality of oxide semiconductor layers 110 in a third direction (i.e., Y direction) vertically intersecting with the first direction and the second direction. In FIG. 1, the plurality of oxide semiconductor layers 110 may include a plurality of oxide semiconductor layer sets 110T, each oxide semiconductor layer set 110T including one or more oxide semiconductor layers 110 of the plurality of oxide semiconductor layers 110 connected to a particular bit line BL of the plurality of bit lines BL and extending in the second direction (i.e., X direction). For example, each of the oxide semiconductor layers 110 of a given oxide semiconductor layer set 110T may be connected to a same particular bit line BL. In FIG. 1, each of the plurality of word lines WL is illustrated as crossing over a corresponding oxide semiconductor layer among the plurality of oxide semiconductor layers 110, but the inventive concepts are not limited thereto, and the plurality of word lines WL may also cross under a corresponding oxide semiconductor layer 110.

The vertically stacked memory device 100 may further include a growth substrate 101 and a driving circuit layer 102 provided on the growth substrate 101. The driving circuit layer 102 may include circuits that are connected to an external circuit and perform an input/output operation of receiving data from the outside or outputting data to the outside and an operation of writing data to a capacitor Cap or reading data written to the capacitor Cap.

The plurality of bit lines BL may be provided on the driving circuit layer 102 to be perpendicular to an upper surface of the driving circuit layer 102. In FIG. 1, for convenience, only three bit lines BL arranged in a row at intervals therebetween in the third direction are illustrated. However, in reality, a larger number of bit lines BL may be arranged in two dimensions. For example, the plurality of bit lines BL extending in a vertical direction, that is, in the first direction, may be two-dimensionally arranged on the driving circuit layer 102 at regular intervals in the second direction and the third direction. The plurality of bit lines BL may be arranged in parallel to each other.

In FIG. 1, the plurality of oxide semiconductor layers 110 includes a plurality of oxide semiconductor layer sets 110T connected to separate, respective bit lines BL. As shown in FIG. 1, in some example embodiments each oxide semiconductor layer set 110T includes a separate one or more oxide semiconductor layers 110, or a separate plurality of oxide semiconductor layers 110, that are connected to a corresponding (e.g., separate, respective) bit line BL (e.g., a same bit line BL) among the plurality of bit lines and are spaced apart at intervals in the first direction. Although only two oxide semiconductor layers 110 are illustrated for each separate oxide semiconductor layer set 110T connected to one bit line BL in FIG. 1 for convenience, a larger number of oxide semiconductor layers 110 may be included in each separate oxide semiconductor layer set 110T and arranged at intervals in the first direction. Additionally, within the same layer, the plurality of oxide semiconductor layers 110 may be arranged in parallel to each other at regular (e.g., fixed) intervals in the third direction. For example, the plurality of oxide semiconductor layer sets 110T may extend in parallel and may be spaced apart at regular (e.g., fixed) intervals in the third direction (i.e., Y direction). The plurality of oxide semiconductor layers 110 arranged on the same layer (e.g., at a same distance in the Z direction from the growth substrate 101) may each be connected to corresponding different bit lines among the plurality of bit lines BL. Like the plurality of bit lines BL, the plurality of oxide semiconductor layers 110 may be two-dimensionally arranged at regular intervals in the second direction and the third direction. Each of the plurality of oxide semiconductor layers 110 may extend in the second direction. A first end of each of the plurality of oxide semiconductor layers 110 may be electrically connected to a corresponding one bit line among the plurality of bit lines BL. A second end of each of the plurality of oxide semiconductor layers 110, which is opposite to the first end in the second direction, may be electrically connected to the capacitor Cap.

In FIG. 1, the capacitor Cap is illustrated as a block for convenience, but in reality, the capacitor Cap may include a first electrode, a second electrode, and a dielectric layer disposed between the first electrode and the second electrode. The first electrode of the capacitor Cap may be electrically connected to a second end of a corresponding oxide semiconductor layer among the plurality of oxide semiconductor layers 110. Accordingly, one oxide semiconductor layer 110 and one capacitor Cap may be connected to each other on a one-to-one basis. Although not shown, the second electrode of the capacitor Cap may be connected to a ground line of the vertically stacked memory device 100.

The word lines WL may extend in the third direction to cross over the corresponding plurality of oxide semiconductor layers 110. The plurality of word lines WL may be arranged at intervals in the first direction. In FIG. 1, for convenience, only one word line WL arranged in one layer is illustrated. However, a plurality of word lines WL may be arranged in parallel to each other on one layer at intervals in the second direction.

Although not illustrated in FIG. 1 for convenience, the vertically stacked memory device 100 may further include an insulator material filled in spaces between adjacent bit lines of the plurality of bit lines BL, between adjacent oxide semiconductor layers 110 of the plurality of oxide semiconductor layers 110, between adjacent word lines WL of the plurality of word lines WL, and between the oxide semiconductor layers 110 and the word lines WL corresponding to each other.

Among oxide semiconductor materials, at least one oxide semiconductor layer 110 may include a material (e.g., an oxide semiconductor material) with relatively excellent acid resistance so that the at least one oxide semiconductor layer 110 is not easily etched by an etching solution compared to surrounding insulating materials during a manufacturing process of the vertically stacked memory device 100. For example, at least one oxide semiconductor layer 110 may include an oxide semiconductor material having an etch selectivity of about 5:1 or more with respect to surrounding insulating materials.

For example, the oxide semiconductor material of at least one oxide semiconductor layer 110 may include tin oxide (SnO₂). For example, at least one oxide semiconductor layer 110 of the plurality of oxide semiconductor layers 110 may include an oxide semiconductor material that may include tin oxide (SnO₂). The oxide semiconductor layer 110 (e.g., at least one oxide semiconductor layer 110 of the plurality of oxide semiconductor layers 110) may include only tin oxide (SnO₂), but may also include a multi-component oxide semiconductor material that further includes other metals. For example, the oxide semiconductor material of an oxide semiconductor layer 110 (e.g., at least one oxide semiconductor layer 110 of the plurality of oxide semiconductor layers 110) may further include, in addition to tin (Sn), at least one metal from among indium (In), gallium (Ga), zinc (Zn), aluminum (Al), silicon (Si), and hafnium (Hf) (e.g., at least one of indium (In), gallium (Ga), zinc (Zn), aluminum (Al), silicon (Si), or hafnium (Hf)).

The proportion of tin (Sn) among all metals in the oxide semiconductor material of at least one oxide semiconductor layer 110 may be about 50 at% or more, about 60 at% or more or about 70 at% or more, and about 75 at% or less, about 80 at% or less, about 90 at% or less, or about 100 at% or less. For example, the proportion of tin (Sn) among all metals in the oxide semiconductor material may be about 50 at% or more to about 90 at% or less, about 60 at% or more to about 90 at% or less, about 50 at% or more to about 75 at% or less, or about 60 at% or more to about 75 at% or less. For example, at least one oxide semiconductor layer 110 of the plurality of oxide semiconductor layers 110 may include an oxide semiconductor material having a proportion of tin (Sn) among all metals in the oxide semiconductor material that is about 50 at% or more, about 60 at% or more or about 70 at% or more, and about 75 at% or less, about 80 at% or less, about 90 at% or less, or about 100 at% or less. For example, at least one oxide semiconductor layer 110 of the plurality of oxide semiconductor layers 110 may include an oxide semiconductor material having a proportion of tin (Sn) among all metals in the oxide semiconductor material that is about 50 at% or more to about 100 at% or less, about 50 at% or more to about 90 at% or less, about 60 at% or more to about 90 at% or less, about 50 at% or more to about 75 at% or less, or about 60 at% or more to about 75 at% or less.

Since an oxide of zinc (Zn) may be easily etched by an etching solution, the oxide semiconductor material of at least one oxide semiconductor layer 110 may include zinc (Zn) in a small proportion. For example, the proportion of zinc (Zn) among all metals in the oxide semiconductor material of at least one oxide semiconductor layer 110 may be about 20 at% or less or about 10 at% or less. In some example embodiments, the proportion of zinc (Zn) among all metals in the oxide semiconductor material of at least one oxide semiconductor layer 110 may be 0 at%.

At least one of the oxide semiconductor layers 110 (e.g., each of the plurality of oxide semiconductor layers 110) may include a channel region 110C facing a corresponding word line WL among the plurality of word lines WL in the first direction, a source region 110S in contact with a corresponding bit line BL among the plurality of bit lines BL in the second direction, and a drain region 110D in contact with a corresponding capacitor Cap among the plurality of capacitors Cap in the second direction. Accordingly, the channel region 110C may be located between the source region 110S and the drain region 110D. In some example embodiments, including the example embodiments shown in FIG. 1, the channel region 110C of an oxide semiconductor layer 110 may be defined as a portion of the at least one oxide semiconductor layer 110 that overlaps a corresponding word line WL (e.g., a proximate word line WL to the at least one oxide semiconductor layer 110, a proximate word line WL that is distal from the growth substrate 101 in relation to the at least one oxide semiconductor layer 110, etc.) in the first direction (i.e., Z direction). The oxygen content of the channel region 110C may be different from the oxygen content of the source region 110S and the drain region 110D. In at least one oxide semiconductor layer 110, carriers (e.g., free electrons) are mainly generated by oxygen vacancies. Accordingly, the source region 110S and the drain region 110D may have a relatively high carrier density, that is, a relatively high density of oxygen vacancies, in order to lower contact resistance. In some example embodiments, the channel region 110C may have a relatively low density of oxygen vacancies to increase the threshold voltage and reduce leakage current. In other words, the oxygen content in the channel region 110C may be higher than the oxygen content in the source region 110S and the drain region 110D.

At least one oxide semiconductor layer 110 may form one oxide semiconductor transistor together with one word line WL corresponding thereto. The word line WL may act as a gate of the oxide semiconductor transistor. When a gate signal equal to or higher than the threshold voltage is applied to the word line WL, current may flow along the channel region 110C. Then, a bit line BL and a capacitor Cap corresponding to the bit line BL may be electrically connected to each other, so that data may be written to the capacitor Cap or data written in the capacitor Cap may be read.

Accordingly, at least one oxide semiconductor layer 110 and one capacitor Cap corresponding thereto (e.g., in contact therewith) may form one memory cell. The vertically stacked memory device 100 according to some example embodiments may include a plurality of memory cells arranged two-dimensionally on one layer. Additionally, the vertically stacked memory device 100 may have a structure in which a plurality of layers including a plurality of memory cells arranged two-dimensionally are stacked. Thus, the recording capacity of the vertically stacked memory device 100 may be improved due to the high integration of memory cells.

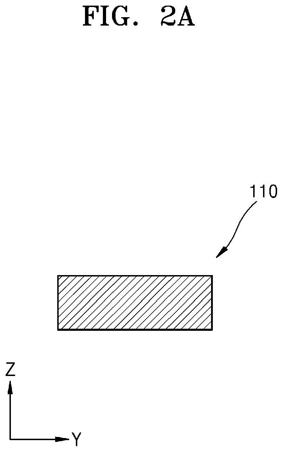

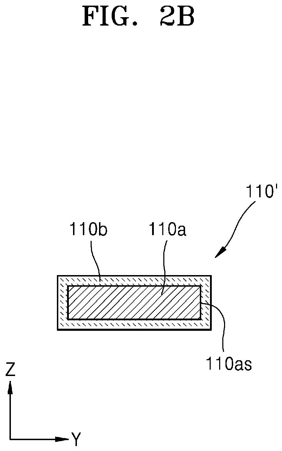

FIGS. 2A and 2B are cross-sectional views illustrating examples of various structures of at least one oxide semiconductor layer 110 of the vertically stacked memory device 100 according to some example embodiments. In particular, FIGS. 2A and 2B illustrate an example of a cross-section of at least one oxide semiconductor layer 110 of FIG. 1 along a plane perpendicular to the second direction, that is, a plane parallel to the first direction and the third direction (e.g., along view line II-II' in FIG. 1).

Referring to FIG. 2A, at least one oxide semiconductor layer 110 according to some example embodiments may include the same type of oxide semiconductor material in the entire area. In other words, the oxide semiconductor material may have the same composition in the entire area of the oxide semiconductor layer 110. For example, as shown in at least FIG. 2A, the oxide semiconductor material of at least one oxide semiconductor layer 110 (e.g., each oxide semiconductor layer 110 of the plurality of oxide semiconductor layers 110) may have a same composition (e.g., uniform material composition) in an entirety of a cross-sectional area of the at least one oxide semiconductor layer (e.g., the cross-sectional area extending in the first and third directions (i.e., Z and Y directions) as shown in FIG. 2A. The composition of the oxide semiconductor material in the entire area (e.g., entirety of the cross-sectional area in the first and third directions) of at least one oxide semiconductor layer 110 may be the same as the composition of tin (Sn) and zinc (Zn) described above.

Referring to FIG. 2B, at least one oxide semiconductor layer 110' according to some example embodiments may include a first oxide semiconductor 110a and a second oxide semiconductor 110b surrounding an outer surface 110as of the first oxide semiconductor 110a (e.g., surrounding in a plane extending in the first and third directions (i.e., Z and Y directions) as shown in FIG. 2B). The second oxide semiconductor 110b may have a function of protecting the first oxide semiconductor 110a from an etching solution. To this end, the content of tin (Sn) in the second oxide semiconductor 110b may be higher than the content of tin (Sn) in the first oxide semiconductor 110a. The content of zinc (Zn) in the first oxide semiconductor 110a may be higher than the content of zinc (Zn) in the second oxide semiconductor 110b.

For example, the proportion of tin (Sn) among all metals in the first oxide semiconductor 110a may be about 50 at% or less, about 30 at% or less, or 0 at%. The proportion of zinc (Zn) among all metals in the first oxide semiconductor 110a may be about 10 at% or about 20 at% or more. For example, the first oxide semiconductor 110a may not include tin (Sn), but may include at least one of zinc indium oxide (ZIO), indium gallium oxide (IGO), and indium gallium zinc oxide (IGZO).

The composition of the second oxide semiconductor 110b may be the same as the composition of tin (Sn) and the composition of zinc (Zn) of the at least one oxide semiconductor layer 110 described above. For example, the proportion of tin (Sn) among all metals in the second oxide semiconductor 110b may be about 50 at% or more, about 60 at% or more or about 70 at% or more, and about 75 at% or less, about 80 at% or less, about 90 at% or less, or about 100 at% or less. The proportion of zinc (Zn) among all metals in the second oxide semiconductor 110b may be about 20 at% or less or about 10 at% or less. In some example embodiments, the proportion of zinc (Zn) and the proportion of tin (Sn) among all metals in the second oxide semiconductor 110b may be 0 at% and 100 at%, respectively. For example, the second oxide semiconductor 110b may include only SnO₂.

The thickness of at least one oxide semiconductor layer 110 or 110' in the first direction (i.e., Z direction) may be about 20 nm or less. Regarding the at least one oxide semiconductor layer 110', the total thickness of the second oxide semiconductor 110b in the first direction (i.e., Z direction) may be about 20% or more to about 40% of the total thickness of the at least one oxide semiconductor layer 110' in the first direction. For example, the thickness of the second oxide semiconductor 110b in the first direction may be about 2 nm or more to about 4 nm or less, or about 3 nm.

While FIG. 2B shows an oxide semiconductor layer 110' may have two discrete oxide semiconductors 110a and 110b having discrete compositions with respective contents of tin (Sn), example embodiments are not limited thereto. For example, in some example embodiments, at least one oxide semiconductor layer 110 or 110' of the plurality of oxide semiconductor layers may have a composition in which a content of tin (Sn) gradually (e.g., continuously, etc.) decreases from an outside (e.g., outer surface) of the at least one oxide semiconductor layer to an inside (e.g., the center in a plane extending in the first and third directions) of the at least one oxide semiconductor layer, for example.

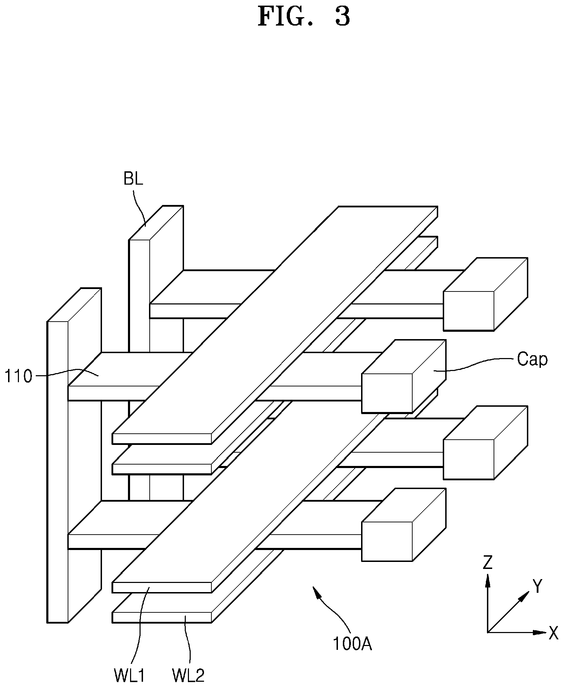

FIG. 3 is a perspective view illustrating a schematic structure of a vertically stacked memory device according to some example embodiments. Referring to FIG. 3, a vertically stacked memory device 100A may have a double gate structure. For example, the vertically stacked memory device 100A may include a first word line WL1 extending in a third direction to cross over a plurality of oxide semiconductor layers 110 arranged in the same memory cell and a second word line WL2 extending in the third direction to cross under the plurality of oxide semiconductor layers 110 arranged in the same memory cell. The first word line WL1 and the second word line WL2 may be arranged in parallel to each other and to face each other and be spaced apart from each other in the first direction with a corresponding oxide semiconductor layer 110 therebetween. In other words, each of the plurality of word lines WL illustrated in FIG. 1 may be regarded as including the first word line WL1 and the second word line WL2 which are spaced apart from each other in the first direction with a corresponding oxide semiconductor layer among the plurality of oxide semiconductor layers 110 therebetween and are arranged in parallel to each other and face each other.

At least one oxide semiconductor layer 110 may form one oxide semiconductor transistor together with the first word line WL1 and the second word line WL2 which correspond to the one oxide semiconductor layer 110. The operation of one oxide semiconductor transistor may be controlled jointly by the first word line WL1 disposed above the at least one oxide semiconductor layer 110 and the second word line WL2 disposed below the at least one oxide semiconductor layer 110. Accordingly, the driving reliability of the oxide semiconductor transistor may be improved. Since other structures of the vertically stacked memory device 100A illustrated in FIG. 2 may be the same as the structures of the vertically stacked memory device 100 illustrated in FIG. 1, detailed descriptions are omitted.

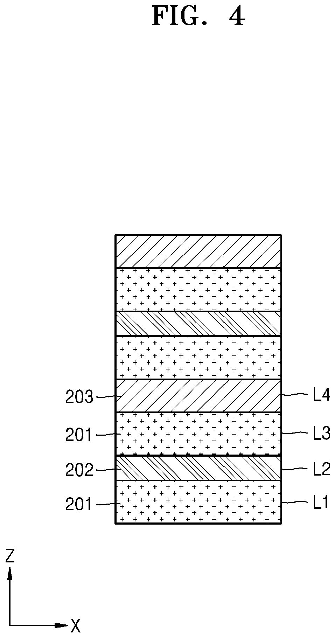

FIGS. 4, 5, 6, 7, 8, 9, 10, 11, 12, 13, 14, 15, 16, 17, 18, 19, 20, 21, 22, 23, 24, 25, 26, 27, and 28 illustrate a process for manufacturing the vertically stacked memory device 100A illustrated in FIG. 3, according to some example embodiments. It will be understood that the process shown in FIGS. 4 to 28 may be applied to manufacture the vertically stacked memory device 100 illustrated in FIG. 1 having one or more oxide semiconductor layers 110 and/or 110' as shown in FIG. 2A and/or 2B.

Referring to FIG. 4, a first layer L1 including a first insulator 201, a second layer L2 including a sacrificial layer material 202, and a third layer L3 including the first insulator 201, and a fourth layer L4 including a second insulator 203 that is different from the first insulator201 may be sequentially stacked in the first direction (i.e., Z direction). In addition, the first to fourth layers L1, L2, L3, and L4 may be repeatedly stacked in multiple sets. A set of sequentially stacked first to fourth layers L1, L2, L3, and L4 may be a unit stacked structure for forming one layer of memory cells.

The first insulator 201 provided in the first layer L1 and the third layer L3 may function as an insulating film within a layer in which one memory cell is disposed. Additionally, the sacrificial layer material 202 provided in the second layer L2 may act as a sacrificial layer for forming an oxide semiconductor layer. The second insulator 203 provided in the fourth layer L4 may act as an interlayer insulating film between a plurality of memory cells stacked in the first direction. The first insulator 201 may include, for example, at least one material selected from silicon nitride (SiNₓ), silicon oxynitride (SiONₓ), and aluminum oxide (Al₂O₃). The sacrificial layer material 202 may include, for example, polysilicon (p-Si). The second insulator 203 may include, for example, silicon oxide (SiO₂).

In the following manufacturing process, only one unit stacked structure is described for convenience, but the following description may be equally applied to the entire stacked structure in which the first to fourth layers L1, L2, L3, and L4 are repeatedly stacked in multiple sets.

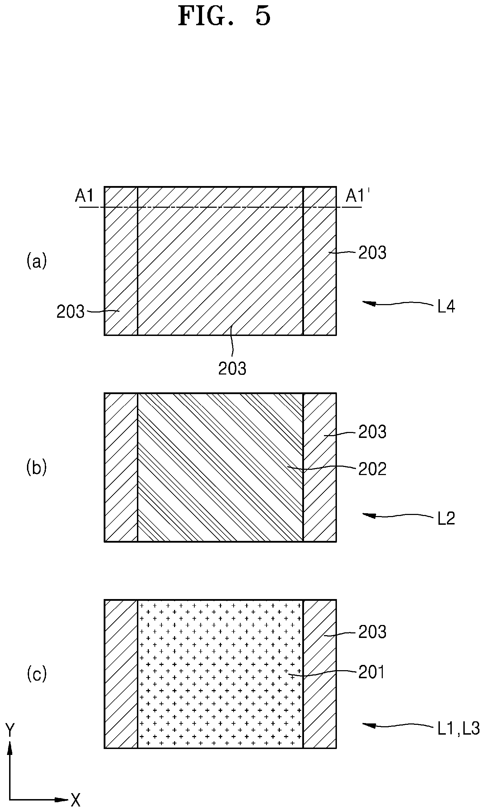

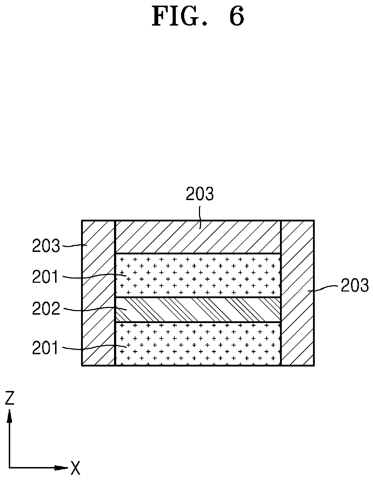

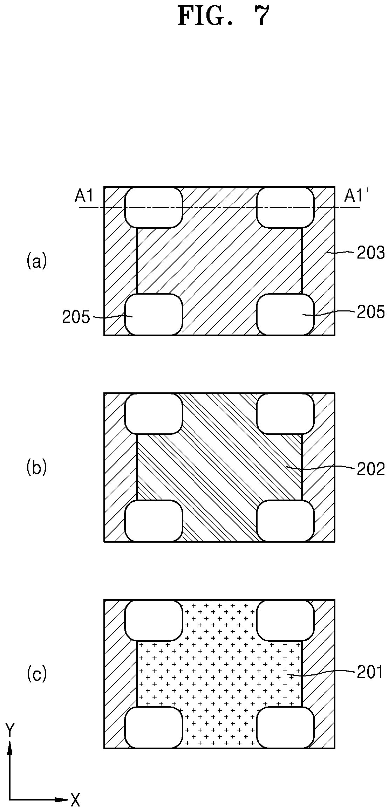

Referring to FIGS. 5 and 6, a first end and a second end of a stacked structure in the second direction may be partially etched, and regions of the etched first end and the etched second end may be filled with the second insulator 203. In FIG. 5, (a) shows a horizontal cross-section of the fourth layer L4, (b) shows a horizontal cross-section of the second layer L2, (c) shows horizontal cross-sections of the first layer L1 and the third layer L3. In other words, FIG. 5 is a cross-sectional view illustrating the cross-sectional shape of layers including different materials cut in a plane perpendicular to the first direction. In the entire process, the first layer L1 and the third layer L3 may have substantially the same horizontal cross-sectional shape. FIG. 6 illustrates a vertical cross-section of the unit stack structure cut along line A1-A1' in FIG. 5. In other words, FIG. 6 is a cross-sectional view illustrating a cross-sectional shape along a plane perpendicular to the third direction. FIGS. 7, 9, 11, 13, 15, 17, 19, 21, 23, 25, and 27 described below illustrate the same cross-section as FIG. 5, and FIGS. 8, 10, 12, 14, 16, 18, 20, 22, 24, 26, and 28 illustrate a cross-sect ion in the same direction as FIG. 6.

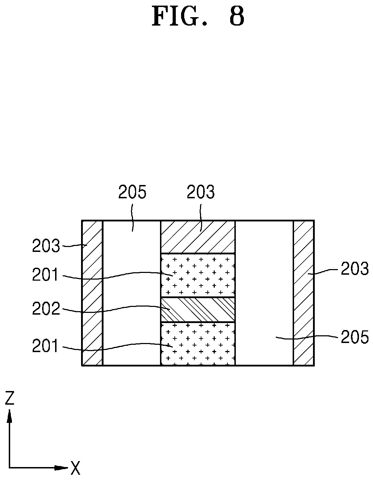

Referring to FIGS. 7 and 8, a plurality of vertical holes 205 penetrating the first to fourth layers L1, L2, L3, and L4 may be formed. The plurality of vertical holes 205 may be formed to penetrate, for example, regions near four corners of the sacrificial layer material 202.

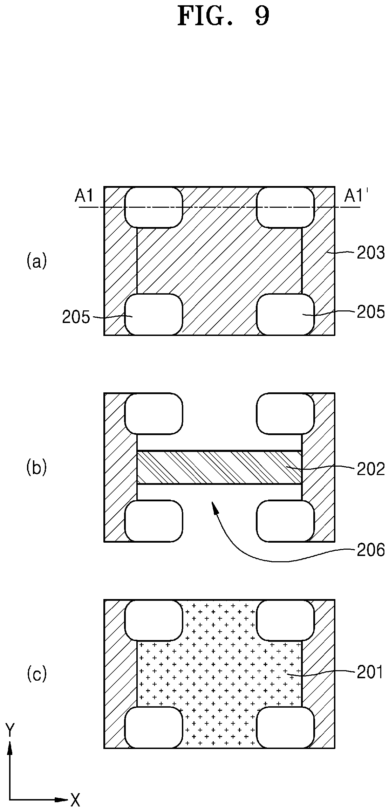

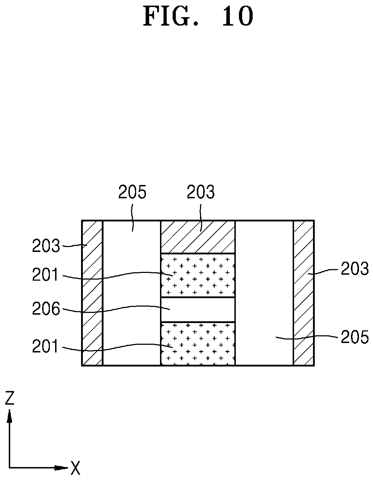

Referring to FIGS. 9 and 10, the sacrificial layer material 202 including polysilicon may be partially removed by supplying an etching solution through the plurality of vertical holes 205. The etching solution may include, for example, a hydrofluoric acid (HF) solution that may dissolve only polysilicon. Then, the sacrificial layer material 202 adjacent to the plurality of vertical holes 205 may be removed, and a space 206 that is empty may be formed in a place where the sacrificial layer material 202 was removed. For example, the space 206 may be formed at both edges (e.g., opposite edges) in the third direction (e.g., Y direction), and the sacrificial layer material 202 may partially remain in the second direction at a center in the third direction.

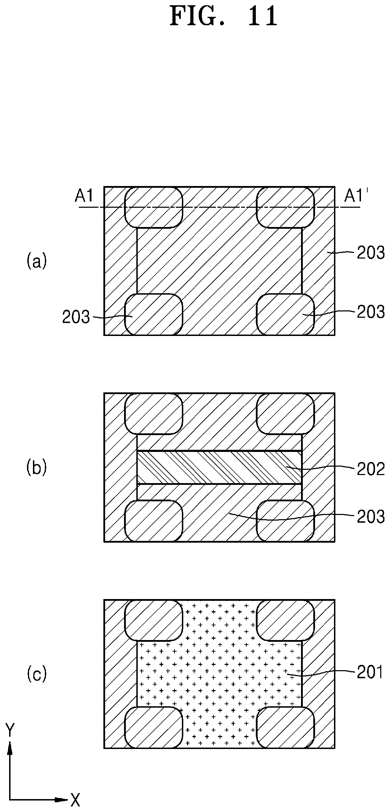

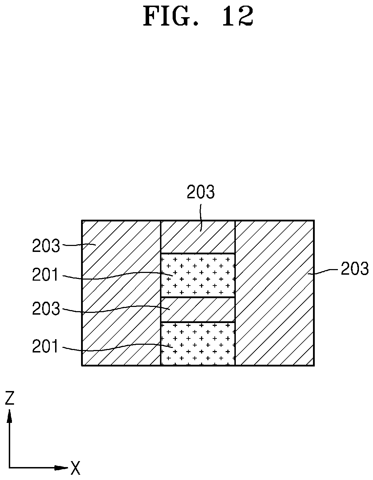

Referring to FIGS. 11 and 12, by supplying the second insulator 203 through the plurality of vertical holes 205, the space 206 in the second layer L2 and the plurality of vertical holes 205 may be filled (partially or entirely filled) with the second insulator 203.

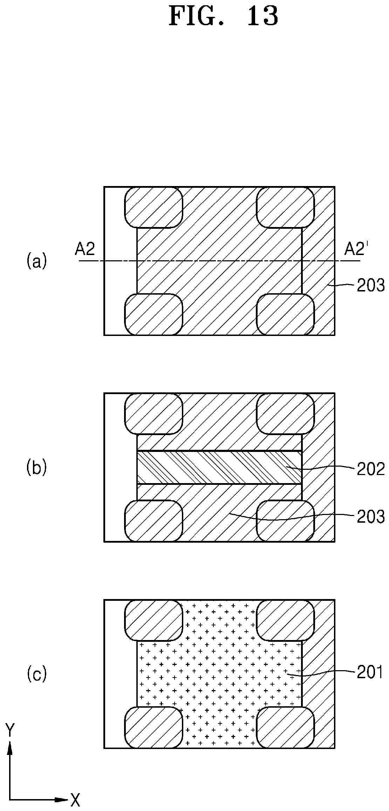

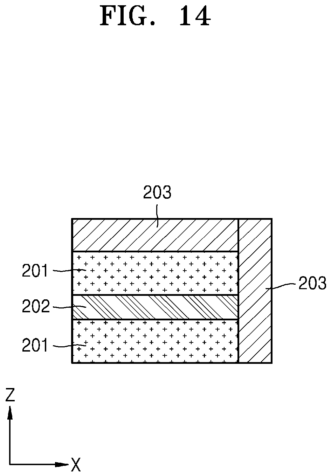

Referring to FIGS. 13 and 14, a first end region of the stacked structure in the second direction (i.e., X direction) may be removed through etching. FIG. 14 illustrates a vertical cross-section of a unit stack structure of FIG. 13 cut along line A2-A2'. In other words, FIG. 14 illustrates a cross-section of the unit stacked structures cut at a center in the third direction along a plane perpendicular to the third direction. As illustrated in FIG. 14, etching may be performed such that a first end of the first insulator 201 in the second direction in the first layer L1 and the third layer L3 may be exposed to the outside (e.g., an external environment) and a first end of the remaining sacrificial layer material 202 in the second layer L2 in the second direction is exposed to the outside. To this end, only the second insulator 203 at the first end of the stacked structure in the second direction may be removed.

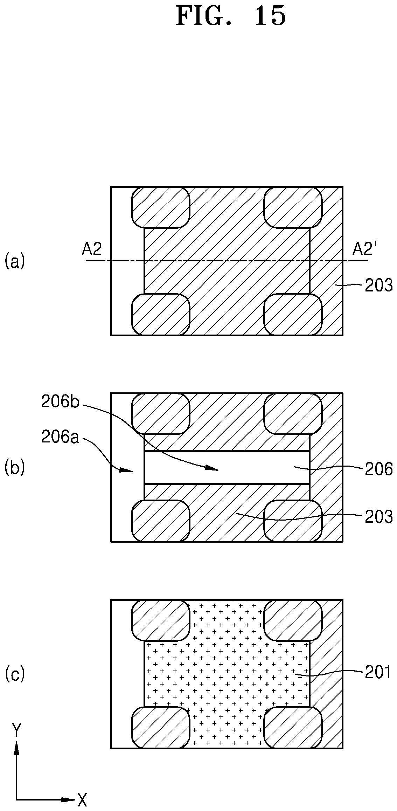

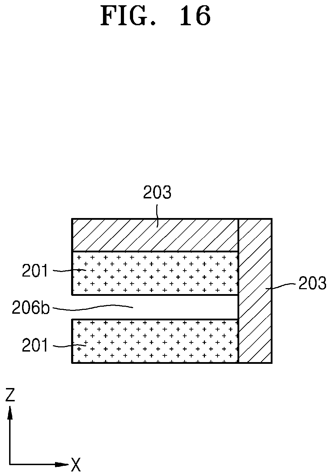

Referring to FIGS. 15 and 16, an etching solution may be supplied through a space 206a formed by removing the second insulator 203 at the first end of the stacked structure in the second direction, then the remaining sacrificial layer material 202 may be completely removed. Then, the empty space 206b may be formed in the second direction at the center of the second layer L2 in the third direction.

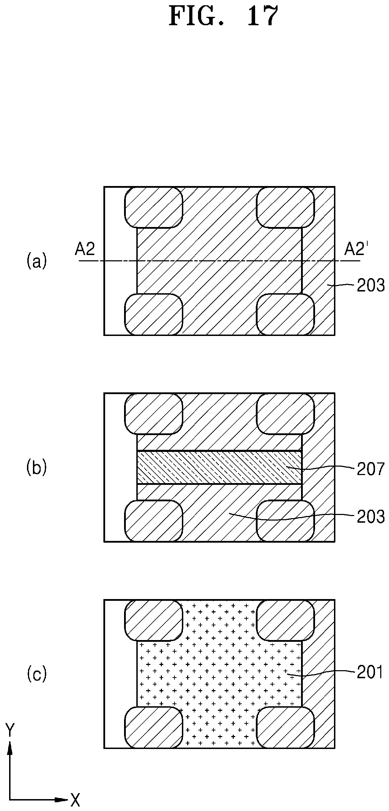

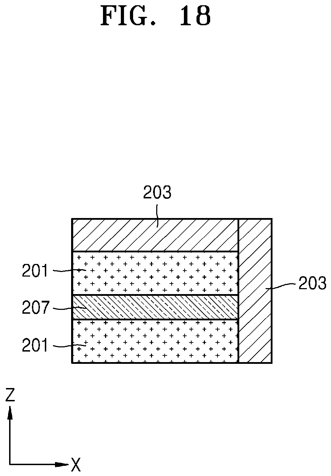

Referring to FIGS. 17 and 18, an oxide semiconductor layer 207 (e.g., at least one oxide semiconductor layer 207) may be formed by depositing an oxide semiconductor in the empty space 206b of the second layer L2. The oxide semiconductor layer 207 (which herein may refer to at least one oxide semiconductor layer 207) may correspond to the oxide semiconductor layer 110 illustrated in FIG. 3. The oxide semiconductor may have the composition described above. For example, the proportion of tin (Sn) among all metals in the oxide semiconductor layer 207 may be about 50 at% or more, about 60 at% or more or about 70 at% or more, about 75 at% or less, about 80 at% or less, about 90 at% or less or about 100 at% or less. For example, the proportion of tin (Sn) among all metals in the oxide semiconductor layer 207 may be about 50 at% or more to about 90 at% or less, about 60 at% or more to about 90 at% or less, about 50 at% or more to about 75 at% or less, or about 60 at% or more to about 75 at% or less. The proportion of zinc (Zn) among all metals in the oxide semiconductor layer 207 may be about 20 at% or less, about 10 at% or less, or 0 at%. Then, since the oxide semiconductor layer 207 may have a relatively high etch selectivity with respect to the first insulator 201 and the second insulator 203 in the surroundings, the oxide semiconductor layer 207 may not be damaged or damage may be minimized or reduced in a subsequent etching process.

An oxide semiconductor may be deposited with a constant composition within the space 206, but the oxide semiconductor may also be deposited with a reduced content of tin (Sn). For example, in the initial stage of deposition, the content of tin (Sn) in a raw material gas may be relatively high. Then, after a certain deposition time has elapsed, the content of tin (Sn) in the raw material gas may be reduced. Then, an oxide semiconductor with a relatively high content of tin (Sn) may be formed first along walls of the space, and an oxide semiconductor with a relatively low content of tin (Sn) may be formed inside the first formed oxide semiconductor. In some example embodiments, the content of tin (Sn) in the raw material gas may be gradually reduced while depositing an oxide semiconductor. Then, the final oxide semiconductor layer 207 may include an oxide semiconductor having a composition in which the content of tin (Sn) gradually decreases from the outside to the inside thereof (e.g., in a plane extending in the first and third directions).

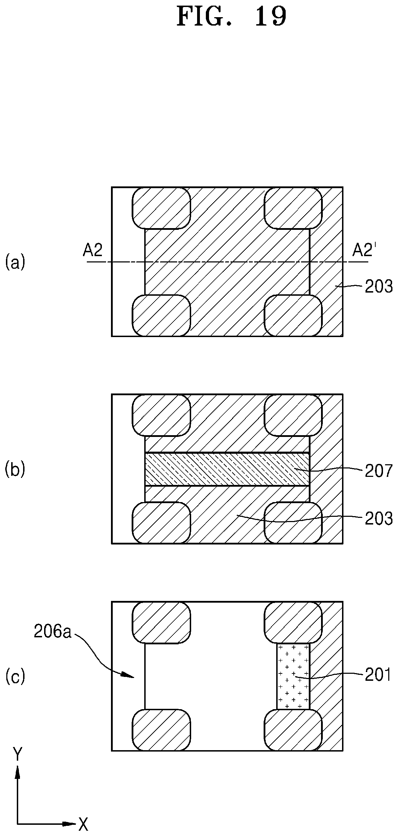

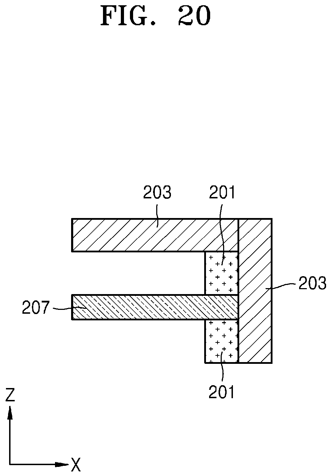

Referring to FIGS. 19 and 20, by supplying an etching solution through the space 206a formed by removing the second insulator 203 at the first end of the stacked structure in the second direction, the first insulator 201 of the first layer L1 and the third layer L3 may be removed. While etching the first insulator 201, the etching time may be appropriately adjusted so that the first insulator 201 is not completely removed. For example, the first insulator 201 may partially remain on an upper surface and a lower surface of a second end of the oxide semiconductor layer 207 (e.g., in a region overlapped in the third direction between two opposing vertical holes 205 as shown). The remaining areas of the upper and lower surfaces of the oxide semiconductor layer 207 may be exposed to the outside. Even if the first insulator 201 is removed, the oxide semiconductor layer 207 may be supported by the second insulators 203 on both sides of the oxide semiconductor layer 207 in the third direction.

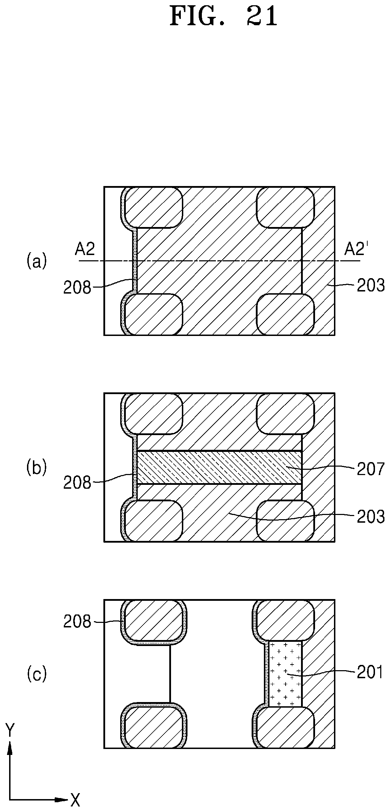

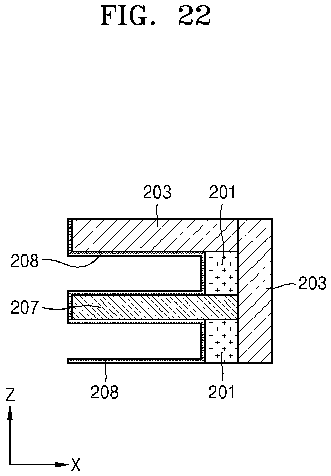

Referring to FIGS. 21 and 22, a gate insulating film 208 may be deposited on exposed surfaces of a first end side of the stacked structure in the second direction. The gate insulating film 208 may be deposited to a certain thickness on the upper surface and the lower surface of the oxide semiconductor layer 207, a surface of the second insulator 203 facing the oxide semiconductor layer 207, and a side surface of the first insulator 201. In this process, the gate insulating film 208 may be partially deposited on a side surface of a first end of the oxide semiconductor layer 207 and a side surface of the second insulator 203. In addition, since the second insulator 203 of another layer or a substrate is further disposed under the oxide semiconductor layer 207 in FIG. 22, the gate insulating film 208 may also be formed under the oxide semiconductor layer 207. The gate insulating film 208 may be formed so as to not completely fill a space between the oxide semiconductor layer 207 and the second insulator 203.

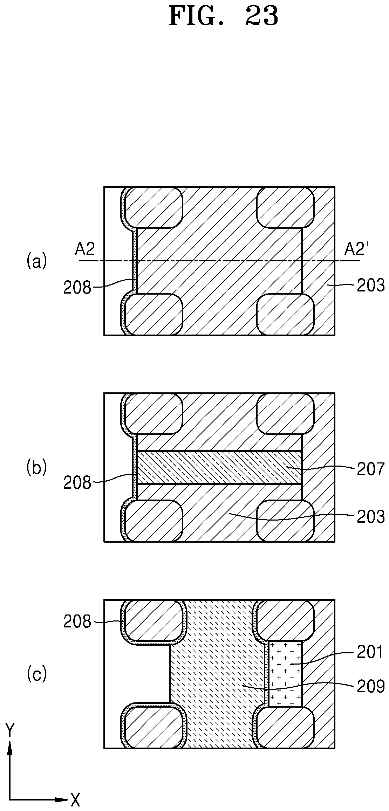

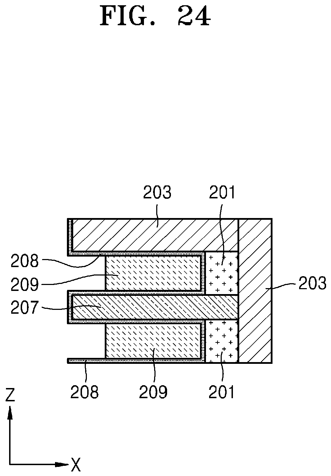

Referring to FIGS. 23 and 24, a word line 209 may be deposited in the space between the oxide semiconductor layer 207 and the second insulator 203 that is not completely filled with the gate insulating film 208. A lower surface, an upper surface, and a second end side surface of the word line 209 formed as above may be surrounded by the gate insulating film 208. Two word lines 209 facing the lower surface and the upper surface of the oxide semiconductor layer 207, respectively may be formed. The word line 209 facing the upper surface of the oxide semiconductor layer 207 may correspond to the first word line WL1 in FIG. 3, and the word line 209 facing the lower surface of the oxide semiconductor layer 207 may correspond to the second word line WL2 of FIG. 3. When forming the word line 209, the word line 209 may be partially formed only on certain areas of the lower surface and the upper surface of the oxide semiconductor layer 207. Accordingly, the oxide semiconductor layer 207 may protrude further than the word line 209 toward the first end in the second direction, leaving a small space between the first end of the word line 209 and the gate insulating film 208.

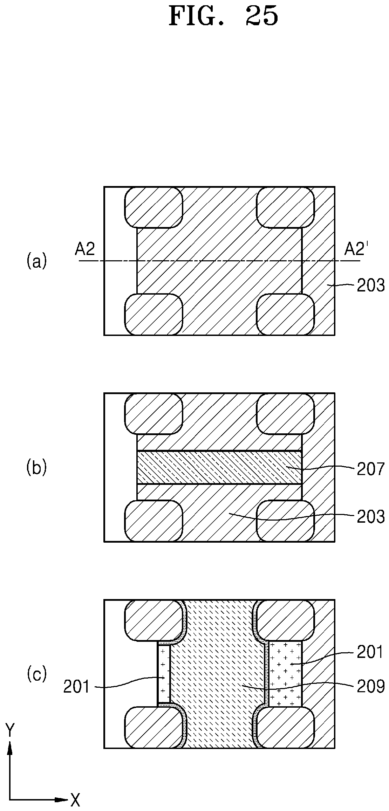

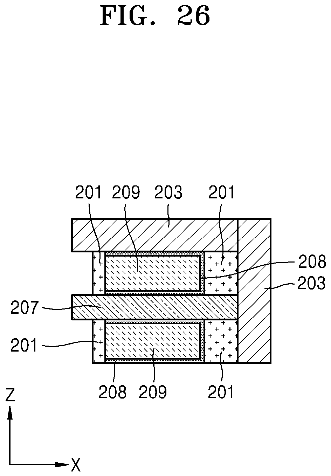

Referring to FIGS. 25 and 26, an unnecessary portion of the gate insulating film 208 may be removed. For example, the gate insulating film 208 formed on the side surface of the first end of the oxide semiconductor layer 207 and the side surface of the second insulator 203 may be removed. Additionally, the gate insulating film 208 formed between the oxide semiconductor layer 207 and the second insulator 203 and protruding further than the first end of the word line 209 may be removed. In other words, the gate insulating film 208 that is not in direct contact with the word line 209 may be removed.

Then, the first insulator 201 may be formed in a space between the oxide semiconductor layer 207 and the second insulator 203 to be in contact with the side surface of the first end of the word line 209. The first insulator 201 may extend in the first direction between the oxide semiconductor layer 207 and the second insulator 203 so as to also contact the gate insulating film 208, and may contact a surface of the oxide semiconductor layer 207 and a surface of the second insulator 203. Accordingly, all surfaces of the word line 209 may be surrounded by an insulating film. For example, the gate insulating film 208 may be in contact with the lower surface, the upper surface, and the second end side surface of the word line 209, and the first insulator 201 may be in contact with the first end side of the word line 209.

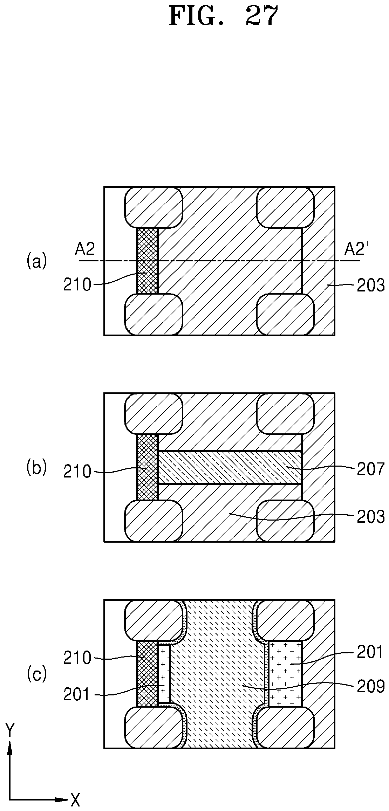

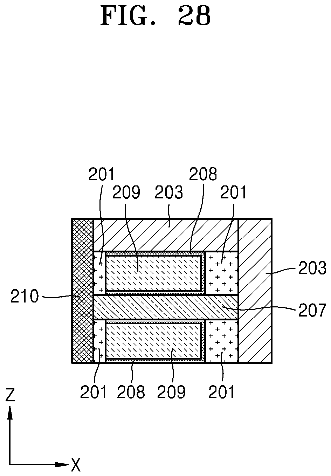

Referring to FIGS. 27 and 28, a bit line 210 may be formed through the first to fourth layers L1, L2, L3, and L4 to contact the first end of the oxide semiconductor layer 207. For example, the bit line 210 may be formed by forming a hole through the center of the stacked structure in the third direction near the first end of the stacked structure, and then filling the hole with a conductive material. The bit line 210 may correspond to the bit line BL illustrated in FIG. 3. The bit line 210 may be formed to contact the first end of the oxide semiconductor layer 207. Additionally, the bit line 210 may be formed to contact the first insulator 201 formed on the side surface of the first end of the word line 209. Accordingly, the word line 209 and the bit line 210 may be electrically separated from each other by the first insulator 201.

In a subsequent process, a second end of the stacked structure in the second direction may be etched and removed, and a capacitor may be further formed to electrically contact the second end of the oxide semiconductor layer 207. Detailed description of the process of forming the capacitor will be omitted.

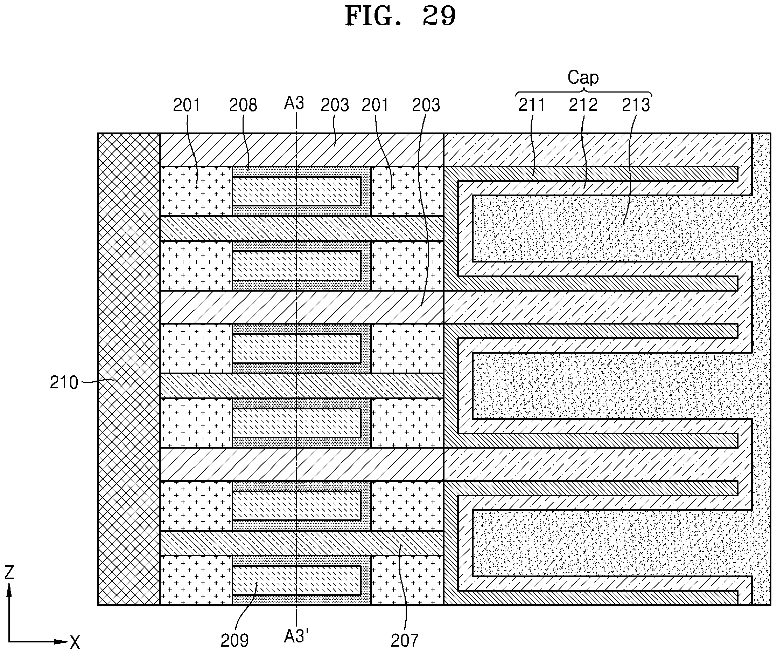

FIG. 29 illustrates a vertical cross-section of a plurality of memory cells of a vertically stacked memory device manufactured through the process illustrated in FIGS. 4 to 28 according to some example embodiments. For example, FIG. 29 illustrates an example of a cross-section at the same position as FIG. 28. Referring to FIG. 29, a plurality of second insulators 203 may be provided to extend in the second direction (i.e., X direction) and be spaced apart from each other in the first direction (i.e., Z direction). One memory cell may be provided between two second insulators 203 adjacent to each other in the first direction. A plurality of memory cells and a plurality of second insulators 203 may be repeatedly stacked in the first direction. In a memory cell, an oxide semiconductor layer 207, two word lines 209 disposed opposite the upper surface and the lower surface of the oxide semiconductor layer 207, and a gate insulating film 208 surrounding each word line 209 may form an oxide semiconductor transistor. Accordingly, a plurality of oxide semiconductor transistors may be stacked at intervals in the first direction. The second insulator 203 may be provided as an interlayer insulating film between two adjacent oxide semiconductor layers 207 in the first direction or between two adjacent oxide semiconductor transistors in the first direction.

The bit line 210 extending in the first direction may contact the first end of the oxide semiconductor layer 207 in the second direction. The bit line 210 may contact all of the plurality of oxide semiconductor layers 207 stacked in the first direction and at least partially overlapping with the bit line 210 in the second direction.

A capacitor Cap may contact the second end of the oxide semiconductor layer 207 in the second direction. The capacitor Cap may include a first electrode 211 electrically connected to the second end of the oxide semiconductor layer 207, a second electrode 213 disposed facing the first electrode 211, and a dielectric layer 212 disposed between the first electrode 211 and the second electrode 213. To increase capacitance, the first electrode 211 may be bent twice, and both ends (e.g., opposite ends) of the first electrode 211 may be extended in the second direction. The second electrode 213 may be provided in a groove between the first electrodes 211 formed by bending.

A plurality of capacitors Cap may be stacked at intervals in the first direction. One oxide semiconductor transistor and one capacitor Cap adjacent to each other in the second direction may form a memory cell. Accordingly, a plurality of memory cells may be stacked at intervals in the first direction.

The width of the word line 209 (e.g., a width of each word line 209) and the width of the gate insulating film 208 (e.g., a width of each gate insulating film 208) in the second direction may be less than the width of the oxide semiconductor layer 207 (e.g., a separate width of each oxide semiconductor layer 207) in the second direction. The first insulator 201 may be disposed to fill a space between the oxide semiconductor layer 207, the word line 209, the bit line 210, and the second insulator 203 and between the oxide semiconductor layer 207, the word line 209, the capacitor Cap, and the second insulator 203. In other words, the first insulator 201 may be provided to fill respective spaces on both sides (e.g., opposite sides) of the plurality of word lines 209 (e.g., each word line 209) in the second direction.

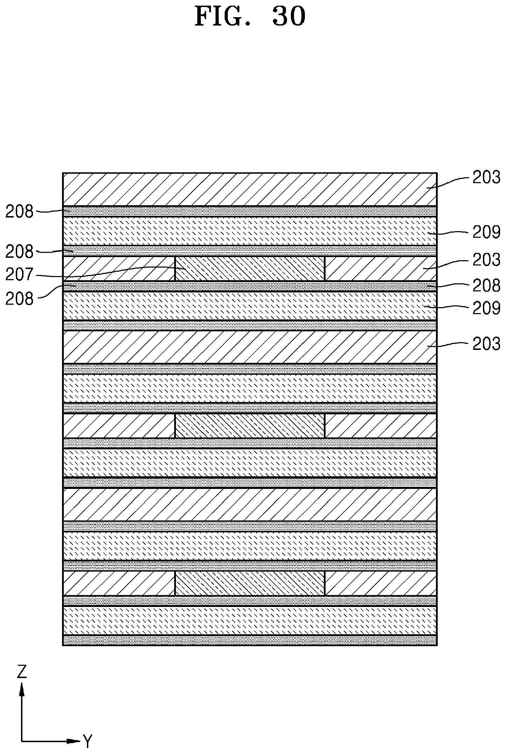

FIG. 30 illustrates a vertical cross-section of a plurality of memory cells of a vertically stacked memory device manufactured through the process illustrated in FIGS. 4 to 28 according to some example embodiments. In particular, FIG. 30 illustrates a vertical cross-section of the vertically stacked memory device illustrated in FIG. 29 along line A3-A3'. In other words, FIG. 30 illustrates a cross-section cut near the center of the oxide semiconductor transistor along a plane perpendicular to the second direction. Referring to FIG. 30, the word line 209 may extend in the third direction. Additionally, the gate insulating film 208 may extend in the third direction in contact with the upper surface and the lower surface of the word line 209.

The oxide semiconductor layer 207 (e.g., at least one oxide semiconductor layer 207) may be disposed between two word lines 209 adjacent to each other in the first direction or between two gate insulating films 208 adjacent to each other in the first direction. The width of the oxide semiconductor layer 207 (e.g., the at least one oxide semiconductor layer 207) in the third direction may be less than the width of the word line 209 (e.g., the separate width of at least one word line 209) in the third direction. The second insulator 203 may be further provided on both sides (e.g., opposite sides) of each oxide semiconductor layer 207 in the third direction.

As described above, a vertically stacked memory device according to some example embodiments may include at least one oxide semiconductor that may be deposited at a relatively low temperature, as a channel material for an oxide semiconductor transistor. Therefore, a plurality of memory cells may be stacked vertically without damage or with reduced damage due to high temperature. Additionally, a vertically stacked memory device according to some example embodiments may include at least one oxide semiconductor having a high etch selectivity to a surrounding insulator as a channel material of an oxide semiconductor transistor. Therefore, damage to an oxide semiconductor channel may be minimized or reduced in the process of etching the insulator around the oxide semiconductor channel after depositing the oxide semiconductor layer, and thus the quality and reliability of the vertically stacked memory device may be improved due to reduced likelihood of process defects resulting from the aforementioned damage.

The vertically stacked memory device described above may be applied to various electronic systems that store information or output and use the stored information.

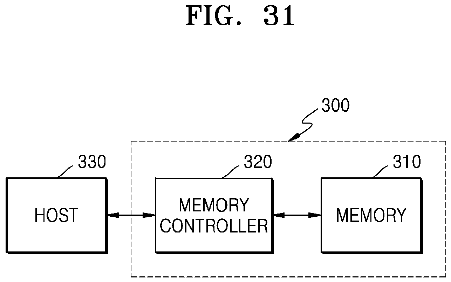

FIG. 31 is a schematic block diagram of an electronic system including a memory device according to some example embodiments. Referring to FIG. 31, an electronic system 300 according to some example embodiments includes a memory device 310 and a memory controller 320. The memory controller 320 may control the memory device 310 to read data from the memory device 310 and/or write data to the memory device 310, in response to a request by a host 330. The memory device 310 may include the memory device 100 according to any of the example embodiments, including any of the example embodiments described above.

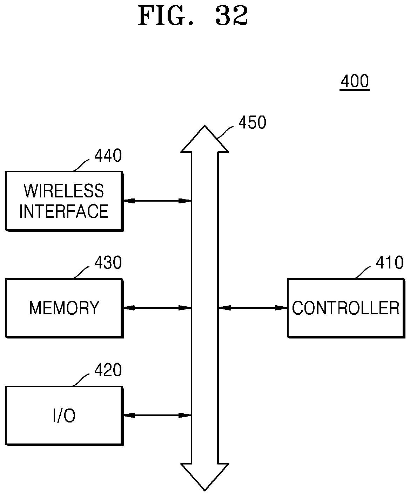

FIG. 32 is a schematic block diagram of another electronic system including a memory device according to some example embodiments. Referring to FIG. 32, an electronic system 400 may configure a wireless communication device or a device capable of transmitting and/or receiving information in a wireless environment. The electronic system 400 includes a controller 410, an input/output device (I/O) 420, a memory device 430, and a wireless interface 440, which are respectively connected to one another through a bus 450.

The controller 410 may include at least one of a microprocessor, a digital signal processor, or a processing device similar thereto. The input/output device 420 may include at least one of a keypad, a keyboard, or a display. The memory device 430 may be used to store commands executed by the controller 410. For example, the memory device 430 may be used to store user data. The electronic system 400 may use the wireless interface 440 to transmit/receive data over a wireless communication network. The wireless interface 440 may include an antenna and/or a wireless transceiver. The memory device 430 may include the memory device 100 according to any of the example embodiments, including any of the example embodiments described above.

As described herein, any devices, systems, modules, portions, units, controllers, circuits, and/or portions thereof according to any of the example embodiments, and/or any portions thereof (including, without limitation, the electronic system 300, the memory device 310, the memory controller 320, the host 330, the electronic system 400, the controller 410, the input/output device 420, the memory device 430, the wireless interface, any portion thereof, or the like) may include, may be included in, and/or may be implemented by one or more instances of processing circuitry such as hardware including logic circuits; a hardware/software combination such as a processor executing software; or a combination thereof. For example, the processing circuitry more specifically may include, but is not limited to, a central processing unit (CPU), an arithmetic logic unit (ALU), a graphics processing unit (GPU), an application processor (AP), a digital signal processor (DSP), a microcomputer, a field programmable gate array (FPGA), and programmable logic unit, a microprocessor, application-specific integrated circuit (ASIC), a neural network processing unit (NPU), an Electronic Control Unit (ECU), an Image Signal Processor (ISP), and the like. In some example embodiments, the processing circuitry may include a non-transitory computer readable storage device (e.g., a memory), for example a solid state drive (SSD), storing a program of instructions, and a processor (e.g., CPU) configured to execute the program of instructions to implement the functionality and/or methods performed by some or all of any devices, systems, modules, portions, units, controllers, circuits, and/or portions thereof according to any of the example embodiments.

The vertically stacked memory device and the electronic apparatus including the same are described above according to some example embodiments illustrated in the drawings. However, the descriptions are only examples, and one of ordinary skill in the art may understand that various modifications and equivalent example embodiments are possible from the descriptions. Such example embodiments as described should be considered in a descriptive sense only and not for purposes of limitation. The scope of the inventive concepts is defined not by the detailed description of the inventive concepts but by the appended claims, and all differences within the scope will be construed as being included in the inventive concepts.

It should be understood that example embodiments described herein should be considered in a descriptive sense only and not for purposes of limitation. Descriptions of features or aspects within each example embodiment should typically be considered as available for other similar features or aspects in some example embodiments. While some example embodiments have been described with reference to the figures, it will be understood by those of ordinary skill in the art that various changes in form and details may be made therein without departing from the scope as defined by the following claims.

## Claims

1. A memory device, comprising:
a plurality of bit lines extending in a first direction;
a plurality of oxide semiconductor layers including a plurality of oxide semiconductor layer sets, each oxide semiconductor layer set including one or more oxide semiconductor layers of the plurality of oxide semiconductor layers connected to a separate, respective bit line of the plurality of bit lines and extending in a second direction, the second direction intersecting with the first direction;
a plurality of capacitors electrically connected to separate, respective oxide semiconductor layers of the plurality of oxide semiconductor layers; and
a plurality of word lines extending to intersect with the plurality of oxide semiconductor layers in a third direction, the third direction intersecting with both the first direction and the second direction,
wherein at least one oxide semiconductor layer of the plurality of oxide semiconductor layers includes an oxide semiconductor material in which a proportion of tin (Sn) among all metals in the oxide semiconductor material is 50 at% or more to 100 at% or less.

2. The memory device of claim 1, wherein the oxide semiconductor material has a same composition in an entirety of a cross-sectional area of the at least one oxide semiconductor layer, the cross-sectional area extending in the first and third directions.

3. The memory device of claim 2, wherein the proportion of tin (Sn) among all metals in the oxide semiconductor material is 50 at% or more to 75 at% or less.

4. The memory device of claim 2, wherein a proportion of zinc (Zn) among all metals in the oxide semiconductor material is 20 at% or less, and optionally wherein a proportion of zinc (Zn) among all metals in the oxide semiconductor material is 0 at%.

5. The memory device of any preceding claim, wherein
the at least one oxide semiconductor layer of the plurality of oxide semiconductor layers comprises a first oxide semiconductor and a second oxide semiconductor, the second oxide semiconductor surrounding an outer surface of the first oxide semiconductor, and
a content of tin (Sn) in the second oxide semiconductor is higher than a content of tin (Sn) in the first oxide semiconductor, and optionally wherein a proportion of tin (Sn) among all metals in the second oxide semiconductor is 50 at% or more to 100 at% or less.

6. The memory device of claim 5, wherein a proportion of zinc (Zn) among all metals in the second oxide semiconductor is 20 at% or less.

7. The memory device of claim 5 or 6, wherein a proportion of tin (Sn) among all metals in the first oxide semiconductor is 50 at% or less.

8. The memory device of any of claims 5 to 7, wherein a content of zinc (Zn) in the first oxide semiconductor is higher than a content of zinc (Zn) in the second oxide semiconductor, and optionally wherein a proportion of zinc (Zn) among all metals in the first oxide semiconductor is 10 at% or more.

9. The memory device of any of claims 5 to 8, wherein a total thickness of the second oxide semiconductor in the first direction is 20% to 40% of a total thickness of the at least one oxide semiconductor layer in the first direction.

10. The memory device of any preceding claim, wherein the at least one oxide semiconductor layer has a composition in which a content of tin (Sn) gradually decreases from an outside of the at least one oxide semiconductor layer to an inside of the at least one oxide semiconductor layer.

11. The memory device of any preceding claim, wherein the oxide semiconductor material of the at least one oxide semiconductor layer further comprises at least one metal of indium (In), gallium (Ga), zinc (Zn), aluminum (Al), silicon (Si), or hafnium (Hf).

12. The memory device of any preceding claim, wherein
the at least one oxide semiconductor layer of the plurality of oxide semiconductor layers comprises
a channel region facing a corresponding word line among the plurality of word lines in the first direction,
a source region contacting a corresponding bit line among the plurality of bit lines in the second direction, and
a drain region contacting a corresponding capacitor among the plurality of capacitors in the second direction, and
an oxygen content in the channel region is higher than an oxygen content in the source region and the drain region.

13. The memory device of any preceding claim, wherein each word line of the plurality of word lines comprises a first word line and a second word line spaced apart from each other in the first direction with a corresponding oxide semiconductor layer among the plurality of oxide semiconductor layers therebetween, the first word line and the second word line being arranged in parallel to each other and facing each other.

14. The memory device of any preceding claim, wherein
each oxide semiconductor layer set includes a separate plurality of oxide semiconductor layers that are that are connected to a corresponding bit line among the plurality of bit lines and are spaced apart at intervals in the first direction, and
a width of each word line of the plurality of word lines in the second direction is less than a separate width of each oxide semiconductor layer in the second direction, and optionally further comprising:
a first insulator configured to fill spaces on opposite sides of each word line of the plurality of word lines in the second direction; and
a second insulator between two adjacent oxide semiconductor layers of the plurality of oxide semiconductor layers in the first direction,
wherein the first insulator comprises at least one material of silicon nitride, silicon oxynitride, or aluminum oxide, and
wherein the second insulator comprises silicon oxide, and further optionally wherein the second insulator is further on opposite sides of each oxide semiconductor layer of the plurality of oxide semiconductor layers in the third direction.

15. An electronic apparatus, comprising:
a memory device according to any preceding claim; and
a memory controller configured to control the memory device to read data from the memory device or write data to the memory device.
